# FASCICULE DE BREVET EUROPEEN

(11) **EP 1 990 922 B1**
(45) Date de publication et mention de la délivrance du brevet: **01.09.2010**
(21) Numéro de dépôt: 08155674.8
(22) Date de dépôt: 06.05.2008
(51) Int. Cl.: H04B 1/16

(54) **Circuit récepteur**
Empfangsschaltung
Receiver circuit

(30) Priorité: 11.05.2007 FR 0754997
(43) Date de publication de la demande: 12.11.2008
(73) Titulaire: ST MICROELECTRONICS S.A., 92120 Montrouge (FR)
(72) Inventeur: Sirito-Olivier, Philippe, 13500, CARRO PAR MARTIGUES (FR); Calo, Pietro, 74014, LATERZA (TA) (IT); Chiricosta, Mario, CAP 98121 MESSINA (ME) (IT)
(74) Mandataire: de Beaumont, Michel

(56) Documents cités:
- EP-A- 0 231 690
- US-A- 4 691 381
- US-A1- 2001 026 160

## Description

### Domaine de l'invention

La présente invention concerne un circuit récepteur et plus particulièrement un circuit récepteur dans un système de télécommunication.

### Exposé de l'art antérieur

Dans les systèmes modernes de télécommunication de données, le récepteur comprend généralement un étage amplificateur d'entrée analogique couplé à un convertisseur analogique-numérique (ADC), la sortie du convertisseur étant fournie à un processeur de signal numérique (DSP).

Un convertisseur analogique-numérique a de façon générale une plage d'entrée limitée et c'est le rôle de l'étage amplificateur d'entrée d'ajuster dynamiquement la tension du signal d'entrée pour que le convertisseur reçoive toujours un signal situé dans sa plage de fonctionnement. Un problème est que le signal d'entrée de certains systèmes de télécommunication peut varier beaucoup en amplitude. L'amplitude peut par exemple dépendre de la distance entre l'équipement de télécommunication et l'émetteur et de la présence d'objets entre l'équipement et l'émetteur, tels que des immeubles, etc. Par exemple, dans des réseaux de téléphonie mobile, les téléphones mobiles qui sont plus proches d'un mât de télécommunication reçoivent des intensités de signal beaucoup plus élevées que des téléphones mobiles qui sont très proches de la frontière d'une cellule du réseau, très loin du mât. En outre, la réception peut être forte au-dessus du sol mais faible en sous-sol.

On a proposé d'utiliser un amplificateur à gain variable (VGA) pour régler de façon dynamique la tension d'entrée au niveau correct pour le convertisseur analogique-numérique. Toutefois, quand une grande plage de tensions d'entrée est possible, un tel circuit est difficile à réaliser. En outre, ce circuit a une réponse lente à des changements de tension d'entrée et a une forte consommation.

Un tel circuit est décrit par la publication de la demande de brevet EP 0 231 690-A1.

### Résumé de l'invention

Selon un aspect de la présente invention, il est prévu un circuit récepteur comprenant une pluralité d'amplificateurs couplés en série, un premier des amplificateurs recevant un signal d'entrée et chacun des amplificateurs fournissant un signal amplifié ; une pluralité de comparateurs, chacun étant couplé à la sortie de l'un des amplificateurs et comprenant une entrée pour recevoir le signal amplifié ; un circuit d'identification de signal couplé aux sorties des comparateurs et agencé pour déterminer si les sorties des comparateurs représentent valablement des données ; et un circuit de sélection de signal couplé à la sortie d'identification de signal et agencé pour sélectionner le meilleur signal provenant des comparateurs en fonction de la validité des sorties des comparateurs.

les sorties des comparateurs étant ordonnées selon l'amplification du signal amplifié à leurs entrées, le comparateur recevant le signal le plus amplifié étant affecté du rang le plus élevé, le meilleur signal étant déterminé comme le signal valide de rang le plus élevé.

Selon un mode de réalisation de la présente invention, le circuit d'identification de signal comprend un circuit d'échantillonnage agencé pour échantillonner les sorties des comparateurs et pour comparer les échantillons à des valeurs enregistrées pour déterminer si les sorties des comparateurs représentent des données valides.

Selon un mode de réalisation de la présente invention, des comparateurs comprennent une valeur de seuil bas et une valeur de seuil haut, la valeur de seuil haut étant utilisée pour détecter quand une sortie haute du comparateur est fournie, et la valeur de seuil bas étant utilisée pour déterminer quand une sortie basse du comparateur est fournie.

Selon un mode de réalisation de la présente invention, la pluralité d'amplificateurs est constituée d'amplificateurs à gain fixe, et comprenant en outre un amplificateur à gain variable connecté en série avec les amplificateurs à gain fixe.

Selon un mode de réalisation de la présente invention, le circuit comprend en outre un atténuateur couplé sélectivement au premier des amplificateurs pour atténuer sélectivement le signal d'entrée.

Un autre aspect de la présente invention prévoit un dispositif portable comprenant un circuit récepteur couplé à un processeur.

Un autre aspect de la présente invention prévoit un procédé de réception d'un signal de données comprenant : amplifier le signal de données par une pluralité de facteurs d'amplification différents pour produire une pluralité de signaux amplifiés ; comparer la pluralité des signaux amplifiés à au moins une valeur de seuil pour produire une pluralité de signaux de sortie ; déterminer si chacun de la pluralité de signaux de sortie représente valablement des données ; et sélectionner le meilleur signal parmi les signaux de sortie en fonction de la validité des signaux de sortie

, le procédé comprend en outre la détermination du meilleur signal en tant que signal de sortie valide de rang le plus élevé des comparateurs, le rang étant déterminé en fonction de l'amplification du signal amplifié à l'entrée de chaque comparateur.

Selon un mode de réalisation de la présente invention, la détermination de ce que les signaux de sortie représentent des données valides comprend l'échantillonnage des signaux de sortie et la comparaison des échantillons à des valeurs correspondant à des données valides pour déterminer si les sorties des comparateurs représentent des données valides.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 représente de façon schématique un récepteur de télécommunication selon un mode de réalisation de la présente invention ;
la figure 2 représente schématiquement le circuit d'entrée d'un récepteur de télécommunication selon un mode de réalisation de la présente invention ;
la figure 3A représente plus en détail un comparateur de la figure 2 selon un mode de réalisation de la présente invention ;
la figure 3B est un chronogramme illustrant le fonctionnement du comparateur de la figure 3A ;
les figures 4A à 4D sont des chronogrammes illustrant des exemples de signaux dans le circuit de la figure 2 selon un mode de réalisation de la présente invention ; et
la figure 5 représente schématiquement un circuit d'entrée d'un récepteur de télécommunication selon un autre mode de réalisation de la présente invention.

### Description détaillée de l'invention

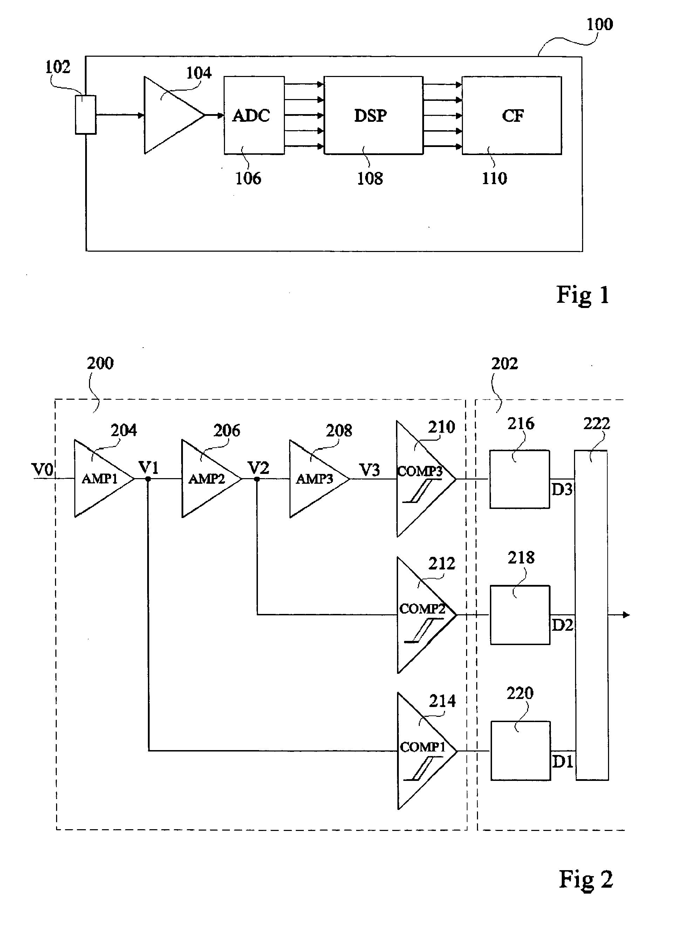

La figure 1 représente schématiquement un récepteur de télécommunication selon un mode de réalisation. Le récepteur 100 comprend un noeud d'entrée 102 qui est par exemple connecté à une antenne ou autre système de détection pour recevoir un signal transmis par un émetteur. Le noeud d'entrée 102 est connecté à un étage amplificateur 104 qui amplifie le signal de sorte qu'il se trouve à l'intérieur d'une plage d'entrée acceptée d'un convertisseur analogique-numérique (ADC) 106. Le convertisseur 106 reçoit le signal de l'amplificateur 104 et produit un signal numérique sur une ou plusieurs lignes de sortie, ce signal étant fourni à un processeur de signal numérique (DSP) ou autre moyen de traitement 108. Le DSP 108 filtre par exemple le signal ou réalise d'autres opérations sur le signal avant de fournir le signal à un autre bloc de fonction de commande (CF) 110 qui est par exemple un système de commande agencé pour réaliser des actions en fonction des bits de données reçus.

L'étage amplificateur 104 doit répondre rapidement à des changements d'amplitude du signal reçu à partir du noeud 102 de sorte que sa sortie, connectée au bloc convertisseur 106, soit toujours à l'intérieur d'une plage requise qui est par exemple comprise entre 0 et 2 volts.

La figure 2 représente schématiquement un étage amplificateur et un bloc convertisseur analogique-numérique selon un mode de réalisation. Le circuit comprend notamment un bloc analogique 200 qui reçoit le signal analogique sur un noeud d'entrée, amplifie le signal et comprend des comparateurs pour convertir le signal analogique en une pluralité de sorties numériques vers un bloc numérique 202. Le bloc numérique 202 sélectionne le meilleur des signaux fournis par le bloc analogique pour transmission au DSP, et néglige les autres signaux comme cela sera décrit plus en détail ci-après.

Le bloc analogique 200 comprend des amplificateurs 204, 206 et 208 couplés en série. L'entrée de l'amplificateur 204 est connectée à un noeud d'entrée (non représenté en figure 2) du circuit récepteur. La sortie de l'amplificateur 208 est couplée à la borne d'entrée d'un comparateur 210. La sortie de l'amplificateur 206 est également couplée à l'entrée d'un comparateur 212. La sortie du comparateur 204 est également couplée à l'entrée d'un comparateur 214. Les comparateurs 210, 212 et 214 fournissent trois sorties numériques du bloc analogique 200 qui sont fournies au bloc numérique 202. Ces comparateurs assurent la fonction d'un convertisseur analogique-numérique.

Le bloc numérique 202 comprend des circuits identificateurs de signal 216, 218 et 220 qui reçoivent respectivement les sorties des comparateurs 210, 212 et 214. Les sorties des identificateurs de signal 216, 218 et 220 sont fournies à un bloc de sélection de signal 222, comprenant par exemple un multiplexeur, qui sélectionne le meilleur de ces signaux pour le fournir à un processeur de signal, par exemple le DSP 108 de la figure 1.

En fonctionnement, l'amplificateur 204 reçoit le signal reçu sur le noeud d'entrée du récepteur. Avant d'être fourni à l'amplificateur 204, le signal est par exemple filtré par un filtre (non représenté). Les amplificateurs 204, 206, 208 amplifient le signal d'une quantité fixe, de sorte que la sortie de chaque amplificateur présente un facteur d'amplification différent, égal à l'amplification de l'amplificateur précédent multipliée par son amplification propre. L'entrée du comparateur 214 a été amplifiée par le seul amplificateur 204 et est donc le signal le plus faible. L'entrée du comparateur 212 a été amplifiée par les amplificateurs 204 et 206 et est donc plus élevée que l'entrée du comparateur 214. L'entrée du comparateur 210 a été amplifiée par tous les amplificateurs 204, 206 et 208 et est donc le signal le plus intense.

A titre d'exemple, en supposant que l'amplificateur 204 amplifie de 40 dB et les amplificateurs 206 et 208 de 30 dB, les sorties des amplificateurs 204, 206 et 208 fournissent des amplifications du signal d'entrée initial V0 de 40, 70 et 100 dB, respectivement.

Selon l'intensité du signal d'entrée, les entrées vers certains des comparateurs peuvent ne pas fournir de signal valide à la sortie du comparateur, si par exemple l'amplitude n'est pas dans la plage requise. Par exemple, si le signal d'entrée est très faible, il se peut que seule l'entrée du comparateur 210 soit suffisante pour fournir un signal valide. A titre de variante, si le signal d'entrée est très élevé, les signaux fournis aux comparateurs 210 et 212 peuvent avoir été suramplifiés d'où il résulte un signal de sortie invalide de ces comparateurs, alors que le comparateur 214 fournit un signal valide. Egalement à titre de variante, il se peut qu'un signal d'entrée ait une amplitude telle que la sortie de l'amplificateur 204 soit trop faible pour le comparateur 214 tandis que la sortie de l'amplificateur 208 est trop forte pour le comparateur 210, alors que l'amplificateur 206 fournit un signal convenable pour le comparateur 212.

Les identificateurs de signal 216, 218 et 220 sont prévus pour déterminer quand les sorties des comparateurs 210, 212 et 214 sont valides. En particulier, ces blocs échantillonnent de préférence les signaux fournis par les comparateurs respectifs 210, 212 et 214 et comparent le motif des valeurs échantillonnées à des formes de signal connues correspondant à des données valides. Quand des données valides sont détectées, un signal de données correspondant D1, D2 et D3 est fourni à partir du bloc identificateur de signal 220, 218 et 216. S'il n'y a pas d'accord valide entre la valeur échantillonnée et des formes connues d'un ou plusieurs identificateurs de signal 216, 218 et 220, aucun signal de données n'est fourni. Un bloc de sélection 222 détecte par exemple un signal de données sur une ligne de données en provenance des identificateurs et sélectionne automatiquement le meilleur signal de données. A titre de variante, les données et un signal "valide" séparé sont par exemple fournis à partir de chaque bloc identificateur de signal 216, 218 et 220 et les signaux "valide" sont utilisés pour commander directement le bloc de sélection 222. Dans ce cas, les identificateurs 216, 218, 220 reçoivent par exemple un signal de synchronisation généré par un bloc non représenté sur la figure. A chaque coup d'horloge du signal de synchronisation, les signaux de données et les signaux "valide" sont transmis.

Le bloc sélecteur de signal 222 choisit la meilleure des valeurs de données de sortie D1, D2 et D3. Il se peut qu'un signal à très bas niveau en provenance de l'un des comparateurs 212 ou 214 fournisse une sortie faible à partir de ces comparateurs vers les blocs respectifs 218 et 220. Une telle sortie peut correspondre à un signal valide qui peut être provoqué par une amplification insuffisante. Egalement, si D3 est invalide et que D2 est valide, D2 est le signal correct. Ainsi, les signaux de sortie sont de préférence ordonnés et le signal valide de rang le plus élevé est de préférence choisi en tant que meilleur signal.

Selon la façon dont les données sont codées pour transmission vers le récepteur, divers types de comparateurs peuvent être utilisés pour détecter le signal d'entrée et fournir une sortie numérique.

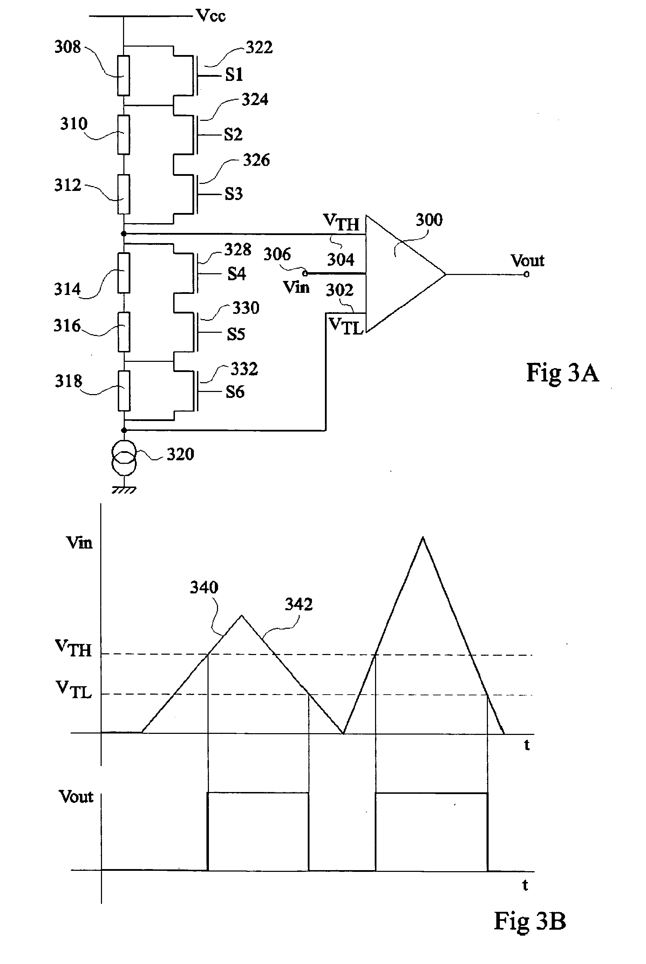

La figure 3 représente un exemple de comparateur 300, par exemple le comparateur 210, 212 ou 214 de la figure 2. Le comparateur 300 comprend une entrée de référence de seuil bas 302, une entrée de référence de seuil haut 304, et une ligne d'entrée supplémentaire 306 pour recevoir la sortie de l'étage amplificateur correspondant. Les valeurs de référence de seuil bas et haut peuvent être des valeurs fixes, déterminées par exemple par un réseau de résistances. Dans l'exemple de la figure 3, un réseau de résistances programmable est prévu de sorte que les valeurs de seuil bas et haut peuvent être réglées. Dans l'exemple illustré, le réseau de résistances comprend des résistances fixes 308, 310, 312, 314, 316 et 318 connectées en série entre une ligne d'alimentation Vcc et un miroir de courant 320 qui est connecté à la masse. Aux bornes de chaque résistance est connecté un transistor respectif 322, 324, 326, 328, 330, 332 de sorte que, lors de l'activation du transistor correspondant par un signal de commande S1 à S6, la résistance associée peut être court-circuitée. Ceci permet au seuil haut sur une entrée 304 du comparateur 300 d'être commandé entre Vcc et Vcc moins la chute de tension aux bornes des résistances 308, 310 et 312. Cela permet également au seuil bas 302 du comparateur 300 d'être commandé entre une valeur de Vcc moins la tension combinée aux bornes des résistances 308, 310 et 312 et Vcc moins la tension aux bornes des six résistances 308, 310, 312, 314, 316, 318 du réseau de résistances. Dans certains modes de réalisation, ceci permet aux valeurs de seuil d'être ajustées en fonction de l'amplitude du signal d'entrée.

Dans des variantes de réalisation, une seule valeur de seuil peut être fournie au comparateur de sorte que le signal est déterminé comme étant haut ou bas selon que sa valeur est en dessus ou en dessous de ce seuil. Toutefois, en fournissant des valeurs de seuil haut et bas, une certaine hystérésis peut être ajoutée au système, ce qui sera expliqué en relation avec la figure 3B.

La figure 3B représente deux chronogrammes illustrant des exemples du signal d'entrée Vᵢₙ et du signal de sortie Vₒᵤₜ du comparateur 300, respectivement. Comme cela est représenté en figure 3B, la valeur de seuil la plus élevée est utilisée pour déterminer quand une valeur précédemment déterminée comme basse devient haute. Ainsi, la tension d'entrée monte selon une rampe 340 et quand cette tension dépasse le seuil supérieur V_{TH}, Vₒᵤₜ passe au niveau haut. Une fois que Vₒᵤₜ est au niveau haut, la valeur de seuil basse V_{TL} est utilisée pour déterminer quand la valeur passe au niveau bas. Ainsi, comme cela est représenté, la tension d'entrée Vᵢₙ descend selon une rampe 342 et, quand la tension chute en dessous du seuil V_{TL}, Vₒᵤₜ passe à nouveau au niveau bas. Ceci peut aider à supprimer un certain bruit de l'entrée, ou bien à éviter une oscillation de la sortie du comparateur si le signal Vᵢₙ varie lentement.

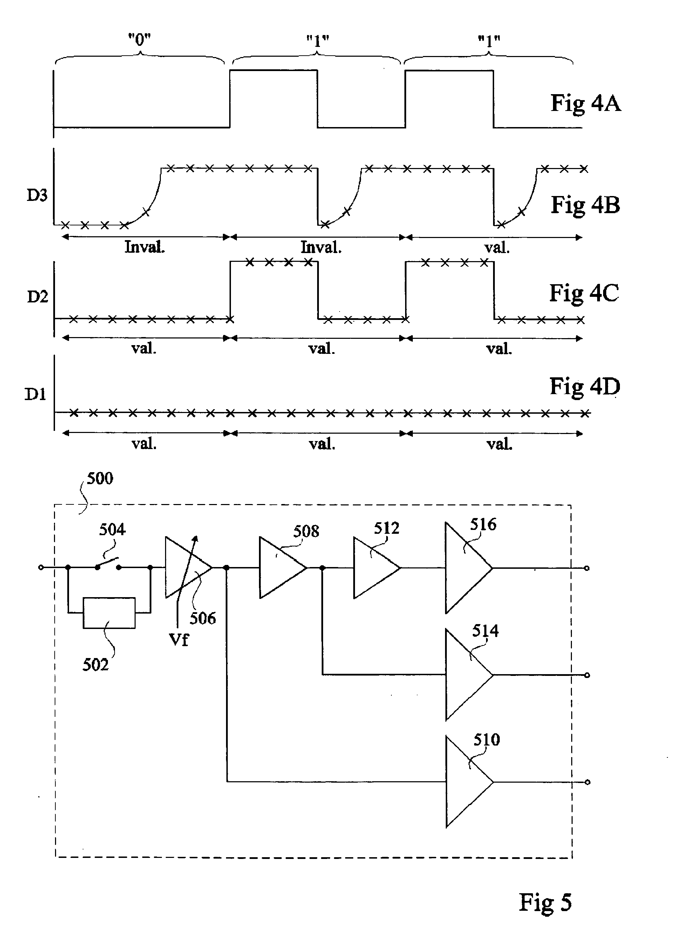

Un exemple du fonctionnement du circuit de la figure 2 va maintenant être fourni en relation avec les figures 4A à 4D.

La figure 4A est un chronogramme illustrant le codage des bits de données transmis selon un exemple. Dans cet exemple, un "0" est codé comme un niveau de tension bas, par exemple 0 V pendant une durée prédéterminée, et un "1" est codé comme une impulsion comprenant un niveau de tension haut suivi d'un niveau de tension bas, la durée combinée du niveau haut et du niveau bas ayant par exemple la même durée que le signal "0". Ainsi, le signal de la figure 4A illustre la transmission de trois bits successifs "011".

La figure 4B représente un exemple du signal de sortie du comparateur 210 résultant de l'émission de "011" illustrée en figure 4A. L'entrée vers le comparateur 210 a été amplifiée du facteur le plus intense. Comme cela est représenté, en raison de la suramplification, le signal à la sortie du comparateur 310 est distordu et passe trop tôt à niveau haut. Toutefois, le front descendant du signal est convenablement positionné. En pratique, ceci est souvent ce qui arrive quand il y a une suramplification. Ce signal est alors fourni au bloc d'identification 216 qui échantillonne le signal. Des exemples des échantillons relevés sont illustrés par des croix en figure 4B. Pendant la durée d'émission du premier bit, plutôt qu'une succession de bas niveaux, en raison de la distorsion du signal, cinq niveaux bas et quatre niveaux hauts sont reçus. Etant donné que cette combinaison ne correspond ni à un bit 0 ni à un bit 1, ce signal est classé comme invalide par le bloc d'identification 216. De même, pendant la durée d'émission du bit 1 suivant, en raison de la distorsion du signal, la durée du bit 1 est basse pendant seulement deux échantillons et haute pendant trois échantillons suivants. Ainsi, on ne peut pas reconnaître un "1" et cette série est classée comme invalide. La sortie de données de l'identificateur de signal 216 est donc invalide pendant deux bits et égale à "1" pendant le troisième bit.

La figure 4C représente un exemple du signal fourni par le second comparateur 212. Dans cet exemple, la sortie de l'amplificateur 206 fournit l'amplification convenable pour le signal d'entrée et ainsi la sortie du comparateur 212 représente avec précision le signal émis. Dans ce cas, tous les bits sont valides. En conséquence, la sortie de données D2 de l'identificateur de signal 218 est "0", "1", "1".

La figure 4D représente un exemple de sortie du comparateur 214 en réponse au signal de la figure 4A. Dans cet exemple, l'amplification par l'amplificateur 204 est insuffisante pour amener le signal au-dessus du seuil du comparateur 214 et on observe donc une succession de valeurs basses. Etant donné que ces valeurs correspondent à un bit "0", le signal D1 est déterminé comme représentant trois bits "0" valides successifs.

Le bloc de sélection de signal 222 détermine par exemple la meilleure sortie en provenance des blocs d'identification de signal 216, 218 et 220 bit par bit. Pour décider quel est le meilleur signal, on donne de préférence à D3 le rang le plus élevé, à D2 un rang médian et à D1 le rang le plus faible. Quand plus d'une des sorties des comparateurs est valide, le signal de rang le plus élevé est utilisé comme sortie. Ainsi, pour le bit "0", le signal D3 est invalide et le bit valide de rang le plus élevé est fourni par D2. Le bit est donc convenablement identifié comme un "0". De même, le signal correspondant au second bit est également déterminé comme invalide par D3 et donc le bit valide de rang le plus élevé est à nouveau fourni par D2 et est en conséquence convenablement identifié comme étant un "1". La troisième valeur de données à la sortie de signal D3 par le bloc d'identification de signal 216 est valide. D3 est le signal de rang le plus élevé et donc ce bit est convenablement identifié comme un "1" en provenance de D3.

La figure 5 représente schématiquement un circuit analogique 500 qui constitue une variante du circuit 200 de la figure 2. Dans cette variante, il est prévu un atténuateur 502 connecté en parallèle avec un commutateur 504, le commutateur 504 et l'atténuateur 502 étant connectés à un amplificateur à gain variable (VGA) 506. L'amplificateur à gain variable 506 est connecté à un amplificateur à gain fixe 508 et à un comparateur 510. La sortie de l'amplificateur 508 est connectée à un autre amplificateur à gain fixe 512 et à un comparateur 514. La sortie de l'amplificateur à gain fixe 512 est fournie à un autre comparateur 516.

Le commutateur 504 permet à l'atténuateur 502 d'être ajouté au circuit d'entrée dans le cas où le signal d'entrée est tellement élevé que la sortie de l'amplificateur 506 serait trop élevée pour une réception convenable du signal par le comparateur 510. Ainsi, le signal peut être atténué "au vol" avant d'être fourni à l'amplificateur 506 de sorte que le facteur d'amplification total est réduit. Ceci est par exemple commandé par un détecteur qui détecte le niveau de tension d'entrée.

L'amplificateur à gain variable 506 fournit un certain gain variable en fonction du niveau du signal d'entrée et est commandé en fonction d'un signal de réaction, par exemple fourni par le bloc 222 de la figure 2 qui détermine si la donnée valide est un bit à "1" provenant de D1. Ainsi, une partie de la plage dynamique de sortie de l'étage amplificateur est fournie par l'amplificateur à gain variable 506 et l'autre partie par la sélection de l'une des trois sorties des comparateurs 510, 514 et 516 de façon similaire à ce qui a été décrit précédemment. Ainsi, par exemple, si une plage d'amplification de 100 dB est requise pour tenir compte des variations du signal d'entrée, l'amplificateur à gain variable 506 pourra fournir une amplification variable de 0 à 40 décibels, tandis que les amplificateurs fixes 508 et 512 pourraient fournir 30 dB d'amplification chacun, assurant la plage totale possible de 100 décibels. Ceci est avantageux par rapport à un circuit comprenant seulement un amplificateur à gain variable ayant une plage de 100 dB car un tel amplificateur est difficile à réaliser, consomme de l'énergie, et répond relativement lentement à des changements de tension d'entrée.

Un avantage du circuit récepteur décrit ici est que l'amplification du signal d'entrée peut être réglée de façon instantanée d'un bit au suivant. En outre, le circuit est efficace en ce qui concerne sa consommation par rapport au circuit utilisant un amplificateur à gain variable. Ceci le rend particulièrement adapté à des applications à faible consommation, par exemple dans des dispositifs qui sont déployés dans un environnement alimenté par une batterie et doivent rester actifs pendant des années.

Les modes de réalisation décrits ici peuvent être incorporés dans une large plage de dispositifs, incluant des dispositifs électroniques portables tels que des téléphones mobiles, des alarmes sans fil anti-effraction, des systèmes de communication de véhicule, etc.

A la lecture des exemples de réalisation ci-dessus, diverses variantes, modifications et améliorations apparaîtront à l'homme de l'art.

Par exemple, bien que dans les exemples ci-dessus des modes de codage particuliers pour des bits "0" et "1" aient été indiqués, dans des variantes de réalisation d'autres codages pourront être utilisés. En outre, d'autres critères peuvent être utilisés pour sélectionner le meilleur signal qui dépendront par exemple du processus de codage utilisé pour les données.

Il sera clair que, bien que des exemples à trois amplificateurs en série aient été fournis, dans des variantes de réalisation, seuls deux amplificateurs en série pourraient être prévus ou plus de trois amplificateurs. Plus le nombre d'amplificateurs est élevé, plus le facteur d'amplification peut être ajusté avec finesse pour un niveau de tension d'entrée particulier.

Les composants numériques du circuit qui ont été décrits comme des éléments matériels pourraient être réalisés sous forme de composants contrôlés par du logiciel.

De telles variantes, modifications et améliorations peuvent être considérées comme faisant partie du domaine de l'invention. Ainsi, la description précédente est donnée uniquement à titre d'exemple et ne doit pas être considérée comme limitative. L'invention est seulement limitée par les revendications ci-après.

## Revendications

1. Circuit récepteur comprenant :
une pluralité d'amplificateurs (204, 206, 208) couplés en série, un premier des amplificateurs recevant un signal de données d'entrée et chacun des amplificateurs fournissant un signal amplifié ;
une pluralité de comparateurs (210, 212, 214), chacun étant couplé à la sortie de l'un des amplificateurs et comprenant une entrée pour recevoir le signal amplifié ;
un circuit d'identification de signal (216, 218, 220) couplé aux sorties des comparateurs et agencé pour déterminer si les sorties des comparateurs représentent valablement des données ; et
un circuit de sélection de signal (222) couplé à la sortie du circuit d'identification de signal et agencé pour sélectionner le meilleur signal provenant des comparateurs en les ordonnant selon l'amplification du signal amplifié à leurs entrées, le comparateur recevant le signal le plus amplifié étant affecté du rang le plus élevé, le meilleur signal étant déterminé comme le signal valide de rang le plus élevé .

2. Circuit récepteur selon l'une quelconque des revendications précédentes, dans lequel le circuit d'identification de signal comprend un circuit d'échantillonnage agencé pour échantillonner les sorties des comparateurs et pour comparer les échantillons à des valeurs enregistrées pour déterminer si les sorties des comparateurs représentent des données valides.

3. Circuit récepteur selon l'une quelconque des revendications précédentes, dans lequel chacun des comparateurs comprend une valeur de seuil bas (V_{TL}) et une valeur de seuil haut (V_{TH}), la valeur de seuil haut étant utilisée pour détecter quand une sortie haute du comparateur est fournie, et la valeur de seuil bas étant utilisée pour déterminer quand une sortie basse du comparateur est fournie.

4. Circuit récepteur selon l'une quelconque des revendications précédentes, dans lequel la pluralité d'amplificateurs est constituée d'amplificateurs à gain fixe, et comprenant en outre un amplificateur à gain variable (506) connecté en série avec les amplificateurs à gain fixe.

5. Circuit récepteur selon l'une quelconque des revendications précédentes, comprenant en outre un atténuateur (502) couplé sélectivement au premier des amplificateurs pour atténuer sélectivement le signal d'entrée.

6. Dispositif portable comprenant un circuit récepteur selon l'une quelconque des revendications précédentes couplé à un processeur.

7. Procédé de réception d'un signal de données comprenant :
amplifier le signal de données par une pluralité de facteurs d'amplification différents pour produire une pluralité de signaux amplifiés ;
comparer la pluralité des signaux amplifiés à au moins une valeur de seuil pour produire une pluralité de signaux de sortie ;
déterminer si chacun de la pluralité de signaux de sortie représente valablement des données ; et
sélectionner le signal de sortie valide de rang le plus élevé des comparateurs, le rang étant déterminé en fonction de l'amplification du signal amplifié à l'entrée de chaque comparateur parmi les signaux de sortie en fonction de la validité des signaux de sortie.

8. Procédé selon la revendication 7, dans lequel la détermination de ce que les signaux de sortie représentent des données valides comprend l'échantillonnage des signaux de sortie et la comparaison des échantillons à des valeurs correspondant à des données valides pour déterminer si les sorties des comparateurs représentent des données valides.

## Claims

1. Receiving circuitry comprising:
a plurality of amplifiers (204, 206, 208) coupled in series, a first of said amplifiers receiving an input data signal and each of said amplifiers outputting an amplified signal;
a plurality of comparators (210, 212, 214) each coupled to the output of one of said amplifiers and comprising an input for receiving said amplified signal;
signal identification circuitry (216, 218, 220) coupled to the outputs of said comparators and arranged to determine whether the outputs of said comparators validly represent data; and
signal selection circuitry (222) coupled at the output of the signal identification circuitry and arranged to select the best signal originating from said comparators by ranking them according to the amplification of the amplified signal at their inputs, the comparator receiving the most amplified signal being given the highest rank, wherein said best signal is determined as the highest ranking valid signal.

2. The receiving circuitry of claim 1, wherein said signal identification circuitry comprising sampling circuitry arranged to sample the outputs of said comparators, and to compare said samples with registered values in order to determine whether said outputs of said comparators represent valid data.

3. The receiving circuitry of any preceding claim, wherein each of said comparators comprises a low threshold value (V_{TL}) and a high threshold value (V_{TH}), said high threshold value being used to detect when a high output from said comparator is provided, and said low threshold being used to determine when a low output from said comparator is provided.

4. The receiving circuitry of any preceding claim, wherein said plurality of amplifiers are fixed gain amplifiers, and further comprising a variable gain amplifier (506) connected in series with said fixed gain amplifiers.

5. The receiving circuitry of any preceding claim, further comprising an attenuator (502) selectively coupled to said first of said amplifiers for selectively attenuating said input signal.

6. A portable device comprising the receiving circuitry of any preceding claim coupled to a processor.

7. A method of receiving a data signal comprising:
amplifying the data signal by a plurality of different amplification factors to generate a plurality of amplified signals;
comparing said plurality of amplified signals with at least one threshold value to generate a plurality of output signals;
determining whether each of said plurality of output signals validly represents data; and
selecting the highest ranking valid output signal from said comparators, wherein said ranking is determined based on the amplification of the amplified signal at the input of each comparator.

8. The method of claim 7, wherein determining whether said output signals represent valid data comprises sampling said output signals and compare said samples with values corresponding to valid data in order to determine whether said outputs of said comparators represent valid data.

## Patentansprüche

1. Eine Empfangsschaltung, die folgendes aufweist:
eine Vielzahl von in Serie geschalteten Verstärkern (204, 206, 208), wobei ein erster der Verstärker ein Eingangsdatensignal empfängt und jeder der erwähnten Verstärker ein verstärktes Signal abgibt;
eine Vielzahl von Vergleichsschaltungen (Komparatoren) (210, 212, 214), wobei jede mit dem Ausgang eines der Verstärker gekoppelt ist und einen Eingang zum Empfang des verstärkten Signals aufweist;
eine Signalidentifikationsschaltung (216, 218, 220) gekoppelt oder verbunden mit den Ausgängen der Vergleichsschaltungen und angeordnet zur Bestimmung, ob die Ausgangsgrößen der Komparatoren in gültiger Weise Daten repräsentieren; und
eine Signalauswahlschaltung (222) gekoppelt an den Ausgang der Signalidentifikationsschaltung und angeordnet zur Auswahl des besten von den Vergleichsschaltungen kommenden Signals, und zwar dadurch, dass die Signale in einer Rangreihenfolge angeordnet werden, entsprechend der Verstärkung des verstärkten Signals, an deren Eingängen,
wobei die Vergleichsschaltung das am meisten verstärkte Signal dem der höchste Rang erteilt wurde empfängt, wobei das erwähnte beste Signal als das am höchsten in der Rangreihenfolge stehende gültige Signal bestimmt ist.

2. Die Empfangsschaltung nach Anspruch 1, wobei die Signalidentifikationsschaltung eine Tast- oder Samplingschaltung aufweist, die angeordnet ist zur Tastung der Ausgangsgrößen der Vergleichsschaltungen und zum Vergleich der Tastwerte mit registrierten Werten, um zu Bestimmen, ob die erwähnten Ausgangsgrößen der Vergleichsschaltungen gültige Daten repräsentieren.

3. Die Empfangsschaltung gemäß einem vorhergehenden Anspruch, wobei jede der erwähnten Vergleichsschaltungen einen niedrigen Schwellenwert (V_{TL}) und einen hohen Schwellenwert (V_{TH}) aufweisen, wobei der hohe Schwellenwert verwendet wird zur Detektierung, wann eine hohe Ausgangsgröße von der Vergleichsschaltung geliefert wird, und wobei die niedrige Schwelle verwendet wird zur Bestimmung, wann eine niedrige Ausgangsgröße von der Vergleichsschaltung geliefert wird.

4. Die Empfangsschaltung nach einem der vorhergehenden Ansprüche, wobei die erwähnte Vielzahl der Verstärker Verstärker mit fester Verstärkung sind, wobei ferner ein Verstärker (506) mit variabler Verstärkung in Serie mit den erwähnten eine feste Verstärkung besitzenden Verstärkern geschaltet ist.

5. Die Empfangsschaltung nach irgendeinem der vorhergehenden Ansprüche, wobei ferner eine Dämpfungsschaltung (Dämpfer) (502) vorgesehen ist, und zwar selektiv gekoppelt mit den erwähnten ersten der erwähnten Verstärker zur selektiven Dämpfung des Eingangssignals.

6. Eine tragbare Vorrichtung, die die Empfangsschaltung irgendeines der vorhergehenden Ansprüche aufweist, und zwar gekoppelt mit einem Prozessor.

7. Verfahren zum Empfang eines Datensignals, wobei folgendes vorgesehen ist:
Verstärken des Datensignals mit einer Vielzahl von unterschiedlichen Verstärkungsfaktoren zur Erzeugung einer Vielzahl von verstärkten Signalen;
Vergleichen der Vielzahl von verstärkten Signalen mit mindestens einem Schwellenwert, um eine Vielzahl von Ausgangssignalen zu erzeugen;
Bestimmen, ob jedes der Ausgangssignale der Vielzahl von Ausgangssignalen in gültiger Weise Daten repräsentiert; und
Auswahl des den höchsten Rang besitzenden gültigen Ausgangssignals von den Vergleichsschaltungen, wobei die erwähnte Rangordnung bestimmt wird basierend auf der Verstärkung des verstärkten Signals am Eingang jeder Vergleichsschaltung.

8. Verfahren nach Anspruch 7, wobei die Bestimmung, ob die erwähnten Ausgangssignale gültige Daten repräsentieren folgendes aufweist:
Tasten der erwähnten Ausgangssignale und Vergleichen der Tastwerte mit Werten entsprechend den gültigen Daten, um zu Bestimmen, ob die erwähnten Ausgangsgrößen der Vergleichsschaltungen gültige Daten repräsentieren.
